# FASCICULE DE BREVET EUROPEEN

(11) **EP 4 348 720 B1**
(45) Date de publication et mention de la délivrance du brevet: **27.08.2025**
(21) Numéro de dépôt: 22730724.6
(22) Date de dépôt: 19.05.2022
(51) Int. Cl.: H10H 20/01, H10H 20/816, H10H 20/821, H10H 20/825

(54) **DISPOSITIF OPTOÉLECTRONIQUE ET PROCÉDÉ DE FABRICATION**
OPTOELEKTRONISCHE VORRICHTUNG UND VERFAHREN ZUR HERSTELLUNG DAVON
OPTOELECTRONIC DEVICE AND METHOD FOR MANUFACTURING SAME

(30) Priorité: 27.05.2021 FR 2105542
(43) Date de publication de la demande: 10.04.2024
(73) Titulaire: Aledia, 38130 Echirolles (FR)
(72) Inventeur: TCHOULFIAN, Pierre, 38000 GRENOBLE (FR); AMSTATT, Benoît, 38000 GRENOBLE (FR); LASSIAZ, Timothée, 38000 GRENOBLE (FR); MALIER, Yoann, 38120 SAINT EGREVE (FR)
(74) Mandataire: Hautier IP
(86) Numéro de dépôt international: PCT/EP2022/063551
(87) Numéro de publication internationale: WO 2022/248326

(56) Documents cités:
- EP-A1- 3 206 237
- WO-A1-2017/200845
- WO-A1-2020/232385
- LIN R-M ET AL: "Improving the Luminescence of InGaN-GaN Blue LEDs Through Selective Ring-Region Activation of the Mg-Doped GaN Layer", IEEE PHOTONICS TECHNOLOGY LETTERS, vol. 19, no. 12, 15 June 2007 (2007-06-15), pages 928 - 930, XP011182351, ISSN: 1041-1135, DOI: 10.1109/LPT.2007.898870
- PIETAK K ET AL: "Phosphorus implantation of Mg-doped (Al)GaN heterostructures: structural examination and depth profiling", J. OF MATERIALS SCIENCE: MATERIALS IN ELECTRONICS, vol. 31, no. 20, 17 September 2020 (2020-09-17), pages 17892 - 17902, XP037300640, ISSN: 0957-4522, DOI: 10.1007/S10854-020-04342-2

## Description

### DOMAINE TECHNIQUE DE L'INVENTION

La présente invention concerne le domaine de l'optoélectronique. Elle trouve pour application particulièrement avantageuse la fabrication de dispositifs optoélectroniques, par exemple des diodes électroluminescentes à base de nanofils de GaN.

### ETAT DE LA TECHNIQUE

Une diode électroluminescente (LED) à base de GaN comprend typiquement des régions d'injection de porteurs (électrons et trous) entre lesquelles est intercalée une région active.

La région active est le lieu où se produisent des recombinaisons radiatives de paires électron-trou, qui permettent d'obtenir une émission de lumière. Cette région active se situe au niveau de la jonction PN. Elle comprend des puits quantiques, par exemple à base d'InGaN.

Les régions d'injection de porteurs permettent de transporter et d'injecter un courant électrique au niveau de la région active. Pour certaines applications, notamment pour des technologies d'affichage, il est préférable de diminuer le courant d'injection dans la LED. Pour conserver un fonctionnement efficace et un rendement radiatif suffisant, il peut être nécessaire d'améliorer ces régions d'injection de porteurs.

La région d'injection de trous est typiquement à base de GaN-p. Lors de sa formation, elle comprend initialement une concentration d'impuretés, par exemple du magnésium Mg, neutralisées par de l'hydrogène absorbé. Ces impuretés « inactives électriquement » doivent être activées pour former des sites accepteurs. Ainsi, pour présenter une conductivité de type p effective, une étape d'activation appliquée à la région d'injection de trous est nécessaire. Cette étape d'activation se fait typiquement par recuit thermique. Lors du recuit, l'hydrogène neutralisant les impuretés est relargué et les impuretés forment alors des sites accepteurs « actifs ». La concentration de ces sites accepteurs, dite concentration d'accepteurs, dépend de l'efficacité de l'étape d'activation.

EP 3206237 A1 divulgue une diode électroluminescente à base de GaN et son un procédé de fabrication comprenant une étape d'activation thermique.

Le document « Yuka Kuwano et al 2013 Jpn. J. Appl. Phys. 52 08JK1208JK12 » divulgue une méthode pour améliorer l'efficacité de l'étape d'activation d'une région d'injection de trous ensevelie sous une couche de GaN de type N. Cette méthode comprend la formation de canaux au sein de l'empilement de couches constituant les régions d'injection de porteurs et la région active, avant activation. Cela permet notamment d'améliorer le relargage d'hydrogène au travers des canaux durant l'activation.

Un inconvénient de cette méthode est que la formation des canaux engendre des défauts et/ou des états d'interface. Cela crée des courants de fuite dont les porteurs ne sont pas injectés dans la région active.

Une autre solution pour améliorer l'injection et/ou le transport du courant depuis les régions d'injection de porteurs vers la région active, consiste à ajouter une ou plusieurs couches de filtrage des porteurs dans l'empilement de la LED. La LED peut ainsi comprendre une couche de blocage d'électrons, dite EBL (Electron Blocking Layer), entre la région d'injection de trous et la région active - de manière à « filtrer » les porteurs, et inversement, une couche de blocage de trous, dite HBL (Hole Blocking Layer), entre la région d'injection d'électrons et la région active. Ces couches peuvent néanmoins dégrader l'émission lumineuse.

Les différentes régions et couches de la LED peuvent être disposées en empilement selon une direction longitudinale z. Une telle architecture de LED est dite axiale. Alternativement, les différentes régions et couches de la LED peuvent être disposées radialement autour de la direction longitudinale z. Une telle architecture de LED est dite radiale ou cœur-coquille. Quelle que soit l'architecture de LED visée, il existe un besoin consistant à améliorer l'injection de trous. La présente invention vise à pallier au moins partiellement les inconvénients mentionnés ci-dessus.

En particulier, un objet de la présente invention est de proposer une diode électroluminescente présentant une région d'injection de trous optimisée. Un autre objet de la présente invention est de proposer un procédé de fabrication d'une telle diode électroluminescente.

Les autres objets, caractéristiques et avantages de la présente invention apparaîtront à l'examen de la description suivante et des dessins d'accompagnement. Il est entendu que d'autres avantages peuvent être incorporés. En particulier, certaines caractéristiques et certains avantages du procédé peuvent s'appliquer *mutatis mutandis* au dispositif, et réciproquement.

### RESUME DE L'INVENTION

Pour atteindre les objectifs mentionnés ci-dessus, un premier aspect concerne une diode électroluminescente à base de GaN tel que défini par la revendication 1.

Seule une partie de la région d'injection de trous - la partie activée - présente une conductivité de type p effective. Cela favorise l'injection de trous dans la région active de la LED au niveau de la partie activée de la région d'injection de trous. Cela limite ou évite le passage du courant au niveau de la partie inactivée de la région d'injection de trous.

Un principe sur lequel est basée la présente invention consiste à délimiter les parties les plus efficaces pour l'injection et/ou la recombinaison de porteurs, en interposant délibérément une couche de blocage d'hydrogène pour éviter l'activation des parties les moins intéressantes pour l'injection et/ou la recombinaison de porteurs. En particulier, on choisira avantageusement de limiter l'injection de trous et la recombinaison de porteurs aux régions de la LED présentant le moins de défauts. Cela permet d'éviter une perte d'efficacité énergétique due aux régions non optimales de la LED - typiquement celles qui présentent le plus de défauts -. Ces dernières sont ainsi volontairement maintenues inactivées.

La couche de blocage d'hydrogène bloque la diffusion d'hydrogène. Ainsi, il est avantageux de disposer une telle couche de blocage d'hydrogène directement sur une partie de la région d'injection de trous, de façon à ce que cette partie soit une partie inactivée. En choisissant la localisation de la couche de blocage d'hydrogène, il est ainsi possible de définir quelle partie de la région d'injection de trous est inactivée. Dans le cas d'une LED 3D à base de nanofils par exemple, il est intéressant que la partie inactivée soit la partie inférieure du ou des nanofils et que la partie activée soit la partie supérieure du ou des nanofils. La partie inférieure du nanofil présente généralement un taux de défauts plus élevé que la partie supérieure. Elle présente dès lors un courant de fuite plus important. Ainsi, seule la partie supérieure participe au transport du courant. Le transport du courant est ainsi optimisé.

Selon un exemple, la partie activée présente une concentration d'accepteurs supérieure ou égale à 10¹⁹cm⁻³, et l'au moins une partie inactivée présente une concentration d'accepteurs inférieure ou égale à 10¹⁶cm⁻³.

Un deuxième aspect concerne un procédé de fabrication d'une telle diode électroluminescente tel que défini par la revendication 15.

Le procédé permet avantageusement d'éviter l'activation d'une partie de la région d'injection de trous. La couche de blocage d'hydrogène formée sur ladite partie avant l'activation thermique empêche un relargage d'hydrogène depuis cette partie lors de l'activation. Cette partie est ainsi inactivée, tandis qu'une autre partie de la région d'injection de trous, non couverte par la couche de blocage d'hydrogène, est activée à l'issue de l'activation thermique.

Ce procédé peut par exemple être appliqué lors de la fabrication d'une LED à base de nanofils. La coquille du nanofil, généralement destinée à former une région d'injection de trous, est couverte sur sa partie inférieure par une couche de blocage d'hydrogène avant activation. Cette couche de blocage d'hydrogène peut ainsi se présenter sous forme de bague sur la partie inférieure du nanofil. La partie inférieure, qui est généralement la partie présentant le taux de défaut le plus élevé, est ainsi inactivée et ne participe pas au transport et à l'injection du courant vers et dans la région active.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
Les FIGURES 1 à 7 illustrent des étapes d'un procédé de fabrication de LED selon un mode de réalisation de la présente invention.
La FIGURE 8 illustre une LED 3D, selon un premier mode de réalisation de la présente invention. La FIGURE 9 illustre une LED 2D, selon un deuxième mode de réalisation de la présente invention.
La FIGURE 10 illustre une LED 3D, selon un troisième mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les dimensions des différentes parties des LED ne sont pas forcément représentatives de la réalité.

### DESCRIPTION DÉTAILLÉE

Avant d'entamer une revue détaillée de modes de réalisation de l'invention, il est rappelé que l'invention selon son premier aspect comprend notamment les caractéristiques optionnelles ci-après pouvant être utilisées en association ou alternativement :
Selon un exemple, la diode électroluminescente comprend une couche dite réservoir d'hydrogène intercalée entre la couche de blocage d'hydrogène et la partie inactivée, ladite couche réservoir d'hydrogène étant configurée pour apporter un supplément d'hydrogène au sein de la partie inactivée au moins lors de l'activation de la partie activée.
Selon un exemple, la couche réservoir d'hydrogène est à base de nitrure de silicium présentant une concentration atomique initiale d'hydrogène comprise entre 0,1% et 10%, voire jusqu'à 20%. Selon un exemple, la couche de blocage d'hydrogène couvre, pour la région d'injection de trous, uniquement l'au moins une partie inactivée.
Selon un exemple, la couche de blocage d'hydrogène est directement au contact de l'au moins une partie inactivée.
Selon un exemple, la région inactivée présente un taux de défauts supérieur au taux de défauts de la région activée. Les défauts sont typiquement ceux qui entraînent une chute d'efficacité dans le transport et/ou la recombinaison des porteurs, par exemple des défauts cristallins.
Selon un exemple, la partie activée présente une concentration d'accepteurs supérieure ou égale à 10¹⁸cm⁻³, et de préférence supérieure ou égale à 10¹⁹cm⁻³.
Selon un exemple, l'au moins une partie inactivée présente une concentration d'accepteurs inférieure ou égale à 10¹⁶cm⁻³, et de préférence inférieure ou égale à 10¹⁵cm⁻³.
Selon un exemple, la diode comprend en outre une couche de passivation s'étendant au contact de la couche de blocage d'hydrogène.
Selon un exemple, la région active se présente sous forme d'une jonction PN entre les régions d'injection de trous et d'électrons.
Selon un exemple, la couche de blocage d'hydrogène est à base de l'un au moins parmi l'AIN, le GaN-n, l'AlGaN-n.
Selon un exemple, les régions d'injection d'électrons et de trous s'étendent le long d'un plan basal, et la couche de blocage d'hydrogène présente au moins une ouverture configurée pour exposer la partie activée de la région d'injection de trous.
Selon un exemple, la région d'injection d'électrons s'étend longitudinalement sous forme de fil et la région d'injection de trous s'étend radialement autour de la région d'injection d'électrons, de sorte que la diode présente une architecture dite cœur-coquille, et la couche de blocage d'hydrogène s'étend radialement sous forme de bague autour de la partie inactivée.
Selon un exemple, la couche de blocage d'hydrogène sous forme de bague est située au niveau d'une base de la diode prenant appui sur un substrat.
Selon un exemple, la couche de blocage d'hydrogène présente une hauteur h₁₂ selon une direction longitudinale z comprise entre 30% et 50% d'une hauteur h_{d} de la diode prise selon la direction longitudinale z.
Selon un exemple, la diode comprend en outre une couche réservoir d'hydrogène s'étendant radialement autour de la partie inactivée, entre la partie inactivée et la couche de blocage d'hydrogène.
Selon un exemple, la diode comprend en outre une couche de passivation s'étendant radialement autour de la couche de blocage d'hydrogène.

L'invention selon son deuxième aspect comprend notamment les caractéristiques optionnelles ci-après pouvant être utilisées en association ou alternativement :
Selon un exemple, le procédé comprend en outre, avant activation, une formation d'une couche de passivation sur la couche de blocage d'hydrogène.
Selon un exemple, le procédé comprend en outre, avant formation de la couche de blocage d'hydrogène, une formation d'une couche réservoir d'hydrogène sur la partie inactivée, de sorte que ladite couche réservoir d'hydrogène soit intercalée entre la partie inactivée et la couche de blocage d'hydrogène. Selon un exemple, une partie de l'hydrogène présent dans la couche réservoir d'hydrogène diffuse dans la partie inactivée, de préférence lors de l'activation.
Selon un exemple, le procédé comprend en outre une formation d'une électrode transparente conductrice sur la partie activée de la région d'injection de trous.
Selon un exemple, la formation de l'électrode transparente conductrice comprend un recuit thermique, et l'activation thermique est configurée pour remplacer ledit recuit thermique.
Selon un exemple, la région d'injection d'électrons est formée sous forme de fil à partir d'un substrat, selon une direction longitudinale z normale à un plan basal du substrat, et la région d'injection de trous est formée radialement autour de la région d'injection d'électrons, de sorte que la diode présente une architecture dite cœur-coquille.
Selon un exemple, la couche de blocage d'hydrogène est formée radialement sous forme de bague autour d'une partie de la région d'injection de trous située au niveau d'une base de la diode au contact du substrat, de sorte que la partie inactivée de la région d'injection de trous soit située au niveau de ladite base de la diode.
Selon un exemple, la formation sous forme de bague de la couche de blocage d'hydrogène comprend les sous-étapes suivantes :
   - un dépôt conforme de la couche de blocage d'hydrogène sur la diode cœur-coquille,
   - un dépôt conforme d'une couche de passivation sur la couche de blocage d'hydrogène,
   - un dépôt par centrifugation d'un matériau de masquage sur une hauteur h22 autour de la couche de passivation,
   - un retrait partiel de la couche de passivation au niveau d'une partie supérieure du fil, par gravure isotrope,
   - un retrait du matériau de masquage,
   - un retrait partiel de la couche de blocage d'hydrogène au niveau de la partie supérieure du fil, par gravure isotrope.

Sauf incompatibilité, des caractéristiques techniques décrites en détail pour un mode de réalisation donné peuvent être combinées aux caractéristiques techniques décrites dans le contexte d'autres modes de réalisation décrits à titre exemplaire et non limitatif, de manière à former un autre mode de réalisation qui n'est pas nécessairement illustré ou décrit. Un tel mode de réalisation n'est évidemment pas exclu de l'invention.

Dans la présente invention, le procédé est en particulier dédié à la fabrication de diodes électroluminescentes (LED), et notamment pour des LEDs à structure 3D.

L'invention peut être mise en œuvre plus largement pour différents dispositifs optoélectroniques. L'invention peut donc être également mise en œuvre dans le cadre de dispositifs laser ou photovoltaïque.

Une LED 3D radiale présente typiquement une partie interne (le cœur) allongée selon z et prenant appui sur un substrat, une région active entourant la partie interne, et une partie externe (la coquille) entourant la région active. La partie interne est généralement destinée à l'injection d'électrons et la partie externe à l'injection de trous. La région active peut se présenter sous forme d'une jonction pn. Alternativement, la région active peut comprendre des puits quantiques s'étendant de façon parallèle à la direction longitudinale z. Une couche de blocage d'électrons peut être présente entre la partie externe et la région active. Une couche de blocage de trous peut être présente entre la partie interne et la région active.

Dans la présente invention, une couche de blocage d'hydrogène est employée pour empêcher l'activation d'une partie de la région d'injection de trous. Cette couche de blocage d'hydrogène présente de préférence une bande interdite et des propriétés cristallines qui empêchent ou minimisent la diffusion d'hydrogène dans la région d'injection de trous. Un matériau approprié pour cette couche de blocage d'hydrogène peut être choisi parmi du GaN non dopé ou du nitrure d'aluminium (AIN) ou un alliage de ces deux matériaux, ou encore un alliage à base d'AlGaN. L'oxyde d'aluminium Al203 ou l'oxyde de magnésium MgO sont également des matériaux appropriés pour cette couche de blocage d'hydrogène.

Sauf mention explicite, il est précisé que, dans le cadre de la présente invention, la disposition relative d'une troisième couche intercalée entre une première couche et une deuxième couche, ne signifie pas obligatoirement que les couches sont directement au contact les unes des autres, mais signifie que la troisième couche est soit directement au contact des première et deuxième couches, soit séparée de celles-ci par au moins une autre couche ou au moins un autre élément. Ainsi, les termes et locutions « prendre appui » et « couvrir » ou « recouvrir » ne signifient pas nécessairement « au contact de ».

Les étapes du procédé telles que revendiquées s'entendent au sens large et peuvent éventuellement être réalisées en plusieurs sous-étapes.

Le terme « structure 3D » s'entend par opposition aux structures dites planaires ou 2D, qui présentent deux dimensions dans un plan très supérieures à la troisième dimension normale au plan. Ainsi, les structures 3D usuelles visées dans le domaine des LED 3D peuvent se présenter sous forme de fil, de nanofil ou de microfil. Une telle structure 3D présente une forme allongée selon la direction longitudinale. La dimension longitudinale du fil, selon z sur les figures, est supérieure, et de préférence très supérieure, aux dimensions transverses du fil, dans le plan xy sur les figures. La dimension longitudinale est par exemple au moins cinq fois, et de préférence au moins dix fois, supérieure aux dimensions transverses. Les structures 3D peuvent également se présenter sous forme de murs. Dans ce cas, seule une dimension transverse du mur est très inférieure aux autres dimensions, par exemple au moins cinq fois, et de préférence au moins dix fois, inférieure aux autres dimensions. Les structures 3D peuvent également se présenter sous forme de pyramides.

Dans la présente demande de brevet, les termes « diode électroluminescente », « LED » ou simplement « diode » sont employés en synonymes. Une « LED » peut également s'entendre d'une « micro-LED ».

Dans la suite, les abréviations suivantes relatives à un matériau M sont éventuellement utilisées : a-M réfère au matériau M sous forme amorphe, selon la terminologie habituellement utilisée dans le domaine de la microélectronique pour le préfixe a-.

p-M réfère au matériau M sous forme polycristalline, selon la terminologie habituellement utilisée dans le domaine de la microélectronique pour le préfixe p-.

De même, les abréviations suivantes relatives à un matériau M sont éventuellement utilisées :
M-i réfère au matériau M intrinsèque ou non intentionnellement dopé, selon la terminologie habituellement utilisée dans le domaine de la microélectronique pour le suffixe -i.
M-n réfère au matériau M dopé N, N+ ou N++, selon la terminologie habituellement utilisée dans le domaine de la microélectronique pour le suffixe -n.
M-p réfère au matériau M dopé P, P+ ou P++, selon la terminologie habituellement utilisée dans le domaine de la microélectronique pour le suffixe -p.

Un objet de la présente invention est d'améliorer l'injection de trous, au niveau de la région dopée P de la LED.

Dans le cadre de la présente demande, un matériau est « effectivement » dopé de type P s'il présente une concentration d'accepteurs [A] supérieure ou égale à 10¹⁹ cm⁻³. Les accepteurs ou sites accepteurs correspondent typiquement à des impuretés non neutres, capables d'accepter au moins un électron (en « donnant » un trou). Des impuretés neutres peuvent devenir non neutres ou actives par l'intermédiaire d'une étape dite d'activation. Ainsi seules les impuretés « activées » participent à la conduction de type P.

Un objet de la présente invention est d'activer une partie seulement de la région d'injection de trous. Cette activation sélective permet notamment de favoriser le passage du courant dans la seule partie activée de la région d'injection de trous. Avantageusement, cette partie activée correspond à la partie de la région d'injection de trous présentant la meilleure qualité cristalline.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi, la région d'injection de trous à base de GaN-p comprend typiquement du GaN et des impuretés de magnésium (Mg).

Un repère, de préférence orthonormé, comprenant les axes x, y, z est représenté sur certaines figures annexées. Ce repère est applicable par extension aux autres figures annexées.

Dans la présente demande de brevet, on parlera préférentiellement d'épaisseur pour une couche et de hauteur pour une structure ou un dispositif. L'épaisseur est prise selon une direction normale au plan d'extension principal de la couche, et la hauteur est prise perpendiculairement au plan basal xy du substrat. Ainsi, une couche présente typiquement une épaisseur selon z, lorsqu'elle s'étend principalement le long d'un plan xy, et une LED présente une hauteur selon z. Les termes relatifs « sur », « sous », « sous-jacent » se réfèrent préférentiellement à des positions prises selon la direction z.

Les valeurs dimensionnelles s'entendent aux tolérances de fabrication et de mesure près.

Les termes « sensiblement », « environ », « de l'ordre de » signifient, lorsqu'ils se rapportent à une valeur, « à 10% près » de cette valeur ou, lorsqu'ils se rapportent à une orientation angulaire, « à 10° près » de cette orientation. Ainsi, une direction sensiblement normale à un plan signifie une direction présentant un angle de 90±10° par rapport au plan.

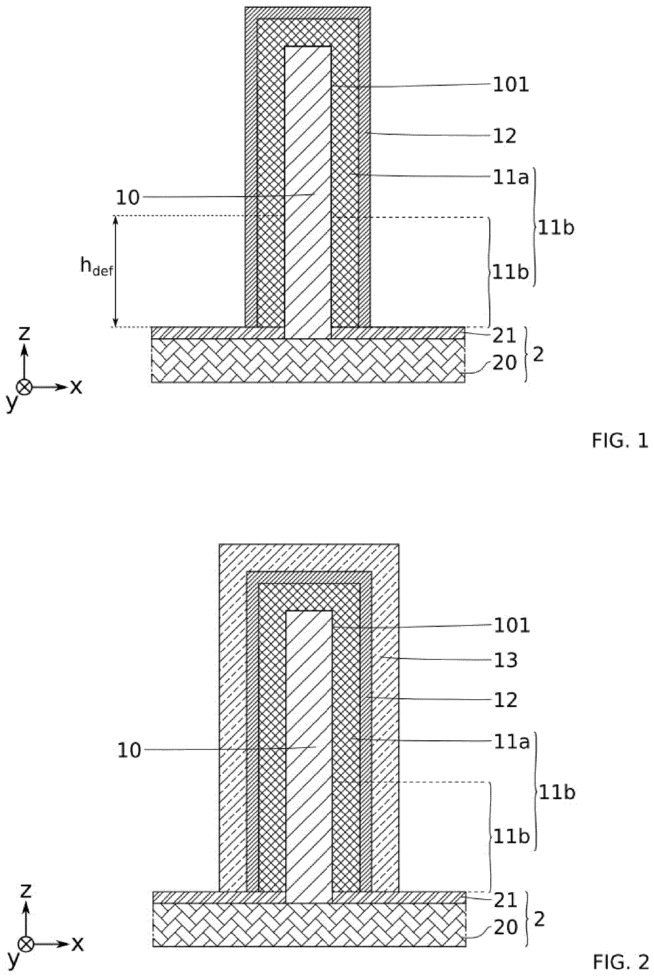

Un premier mode de réalisation du procédé selon l'invention est illustré aux figures 1 à 8. Ce premier mode de réalisation vise à former une LED 3D à architecture cœur-coquille avec une région d'injection de trous optimisée.

Selon ce premier mode de réalisation, une structure de LED 3D est d'abord formée sous forme de fil à partir d'un substrat 2 (figure 1).

Le substrat 2 comprend ici typiquement une couche de nucléation 20 et une couche de masquage 21.

La couche de nucléation 20 est de préférence à base d'AIN. Elle peut être alternativement à base d'autres nitrures métalliques, par exemple GaN-n ou AlGaN. Cette couche de nucléation 20 peut être n'importe quelle couche permettant la nucléation et la croissance du GaN connue par l'homme du métier. Elle peut être formée par épitaxie sur un support (non illustré) en silicium, de préférence par épitaxie en phase vapeur à précurseurs organométalliques MOVPE (acronyme de « Metal Organic Vapour Phase Epitaxy »). Elle présente avantageusement une épaisseur inférieure ou égale à 200 nm, de préférence inférieure ou égale à 100 nm, par exemple de l'ordre de 50 nm.

La couche de masquage 21 est de préférence en un matériau diélectrique, par exemple en nitrure de silicium Si3N4. Elle peut être déposée par dépôt chimique en phase vapeur CVD (acronyme de « Chemical Vapor Deposition ») sur la couche de nucléation 20. Elle masque en partie la couche de nucléation 20 et comprend des ouvertures 210 de préférence circulaires exposant des zones de la couche de nucléation 20. Ces ouvertures 210 présentent typiquement une dimension, par exemple un diamètre ou un diamètre moyen, comprise entre 30 nm et 600 nm.

Un fil de GaN-n est cru à travers une ouverture 210 de la couche de masquage 21. La formation de ce fil peut se faire par épitaxie, de préférence par épitaxie en phase vapeur à précurseurs organométalliques MOVPE (acronyme de « MetalOrganic Vapour Phase Epitaxy »), notamment comme défini dans la publication WO2012136665.

La formation de ce fil peut alternativement se faire par épitaxie par jets moléculaires MBE (acronyme anglais de « Molecular Beam Epitaxy »), par épitaxie en phase vapeur à précurseurs gazeux chlorés HVPE (acronyme de « Hydride Vapour Phase Epitaxy »), par dépôt chimique en phase vapeur CVD et MOCVD (acronyme de « Metal Organic Chemical Vapor Deposition »).

Ce fil de GaN-n est destiné à former la région 10 d'injection d'électron de la LED. De façon connue, le dopage N de cette région 10 peut résulter d'une croissance, d'une implantation et/ou d'un recuit d'activation. Le dopage N peut notamment s'obtenir directement lors de la croissance, à partir d'une source de silicium ou de germanium, par exemple par addition de vapeur silane ou disilane ou germane. Les conditions de croissance requises pour la formation d'un tel fil 10 de GaN-n sont largement connues.

Le fil 10 présente de préférence un diamètre Φ supérieur ou égal à 30 nm et/ou inférieur ou égal à 600 nm. Le fil 10 présente également une hauteur h₁₀ de préférence supérieure ou égale à 150 nm. Ce fil 10 de GaN-n présente de préférence un rapport d'aspect h₁₀/Φ supérieur à 1, et de préférence supérieur à 5.

Le fil 10 de GaN-n forme ici le cœur de la LED 3D à architecture cœur-coquille.

Une coquille 11 en GaN-p peut ensuite être formée sur le cœur 10.

Cette coquille de GaN-p est destinée à former la région 11 d'injection de trous de la LED. Cette région 11 est de préférence formée par épitaxie MOVPE. L'inclusion d'éléments dopants de type P peut notamment s'obtenir directement lors de la croissance, à partir d'une source de magnésium par exemple. Les conditions de croissance requises pour la formation d'une telle coquille 11 de GaN-p sont largement connues.

La coquille 11 peut être formée directement sur le cœur 10, de manière à former une jonction pn. La région active 101 correspond ainsi à cette jonction pn. Alternativement, la région active peut comprendre de façon connue une pluralité de puits quantiques (non illustrés) configurés pour émettre un rayonnement lumineux selon une longueur d'onde principale λ. Ces puits quantiques sont par exemple à base d'InGaN. Ils peuvent être classiquement séparés les uns des autres par des barrières à base d'AlGaN.

La coquille 11 présente typiquement une partie supérieure 11a et une partie inférieure 11b. La partie inférieure 11b s'appuie typiquement sur le substrat 2 et présente une hauteur h_{def}. Cette partie inférieure 11b présente généralement un taux de défauts supérieur à celui de la partie supérieure 11a.

A l'issue de la croissance, le dopage P de la région 11 n'est pas encore effectif. Une étape d'activation, typiquement un recuit thermique sous atmosphère d'azote N2, est en effet nécessaire pour activer les éléments dopants présents dans la région 11. Cette étape vise à éliminer l'hydrogène absorbé au sein de la région 11 et neutralisant les éléments dopants.

Avantageusement, cette étape d'activation n'est pas réalisée à ce stade, de sorte que la coquille 11 n'est pas activée et ne présente pas de conductivité de type P effective. Au contraire, la coquille 11 peut être soumise à une atmosphère sous hydrogène de façon à passiver ou inactiver le GaN-p.

Comme illustré à la figure 1, une couche 12 de type couche de blocage d'hydrogène peut être déposée de façon conforme sur la coquille 11 à base de GaN-p inactivé. La couche 12 de blocage d'hydrogène peut être à base de GaN-n, d'AIN-i, d'AlGaN-n ou d'une combinaison de ces matériaux. La couche 12 peut notamment comprendre un empilement de couches, par exemple une couche d'AIN-i associée à une couche de GaN-n, ou une couche d'AlGaN-n associée à une couche d'AIN-i. La couche 12 de blocage d'hydrogène présente de préférence une épaisseur comprise entre 5 nm et 100 nm, typiquement de l'ordre de 10 nm.

La couche 12 de blocage d'hydrogène est à base d'un matériau présentant de préférence une bande interdite et des propriétés cristallines qui empêchent ou minimisent la diffusion d'hydrogène dans la région d'injection de trous. La couche 12 de blocage d'hydrogène est de préférence à base d'un matériau qui peut être avantageusement déposé par épitaxie et qui est compatible avec les matériaux des régions active et d'injection de trous. Un tel matériau présente notamment un faible désaccord de paramètre de maille avec les matériaux des régions active et d'injection de trous.

La couche 12 est également désignée HyBL, signifiant « couche de blocage d'hydrogène » selon l'acronyme anglais « Hydrogen Blocking Layer ». La présence de cette couche 12 HyBL sur la région 11 peut ainsi empêcher l'activation de la région 11. Un principe de l'invention est de conserver une partie de cette couche 12 HyBL sur une partie de moindre intérêt de la région 11, typiquement la partie inférieure 11b de la région 11, de façon à l'inactiver.

Comme illustré à la figure 2, une couche 13 de passivation peut être déposée de façon conforme sur la couche 12 HyBL. Cette couche 13 de passivation est typiquement à base d'un matériau diélectrique, par exemple à base de nitrure de silicium ou d'oxyde de silicium.

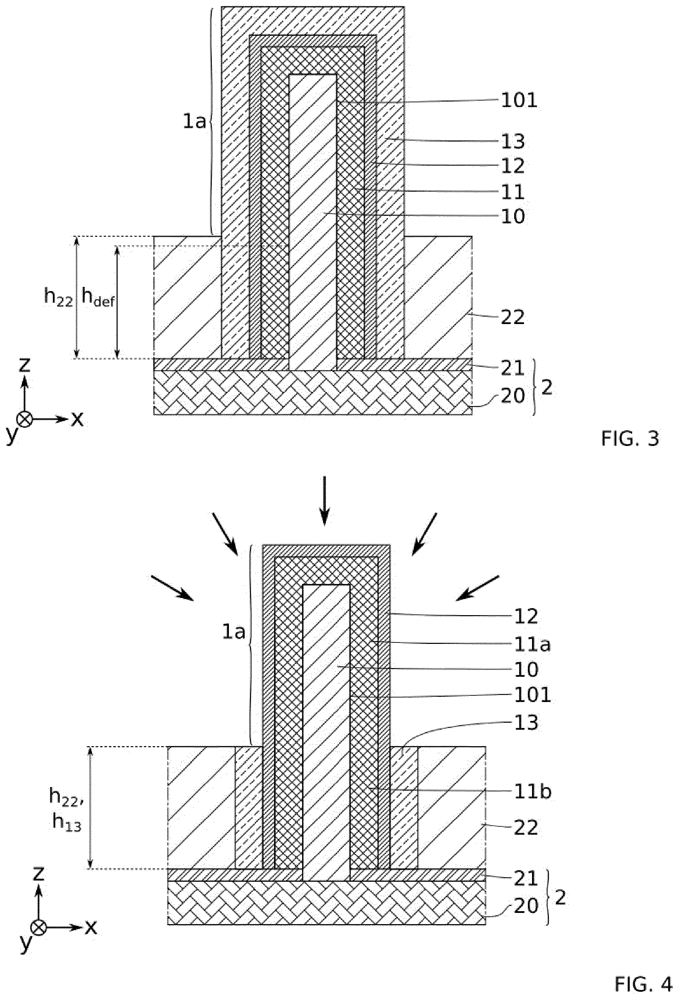

Comme illustré à la figure 3, un matériau 22 de masquage peut être déposé par centrifugation sur une hauteur h₂₂ autour de la couche 13 de passivation. Les conditions de centrifugation sont de préférence choisies telles que h₂₂ ≥ h_{def}. Cela permet de masquer la base de la LED sur toute la hauteur de la partie inférieure 11b de la région 11. Ainsi seule une partie supérieure 1a de la LED n'est pas couverte par le matériau 22 de masquage. Cette partie supérieure 1a correspond de préférence sensiblement à la partie supérieure 11a de la région 11 qui présente le moins de défauts.

Comme illustré à la figure 4, un retrait partiel de la couche 13 de passivation est ensuite effectué au niveau de la partie supérieure 1a de la LED. Ce retrait partiel peut être effectué de façon connue par gravure isotrope du matériau de la couche 13. A l'issue de ce retrait, seule une partie supérieure 1a de la LED n'est pas couverte par la couche 13 de passivation. La partie de la couche 13 couverte par le matériau de masquage 22 est conservée sous forme de bague ou de collier, appelé « collar » en anglais, à la base de la LED. Le collier 13 présente typiquement une hauteur h₁₃ sensiblement égale à la hauteur h₂₂ du matériau 22 de masquage.

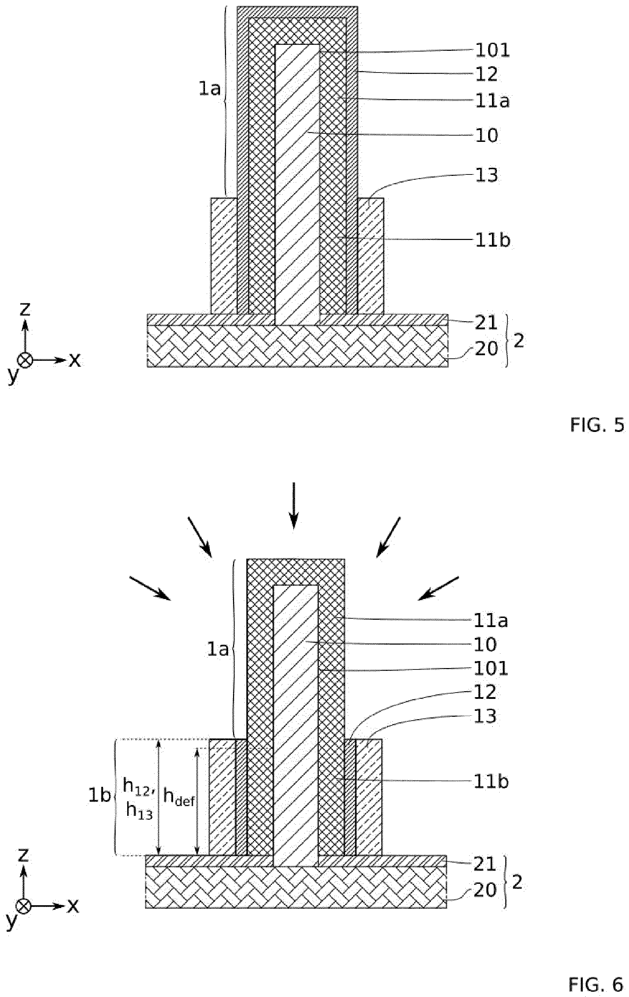

Comme illustré à la figure 5, le matériau 22 de masquage peut ensuite être retiré. A ce stade, le collier 13 entoure la couche 12 HyBL à la base de la LED. La couche 12 HyBL est exposée au niveau de la partie supérieure 1a de la LED.

Comme illustré à la figure 6, la couche 12 HyBL est ensuite partiellement retirée au niveau de la partie supérieure 1a de la LED. Ce retrait partiel peut être effectué de façon connue par gravure isotrope du matériau de la couche 12 sélectivement au matériau de la couche 13. La gravure isotrope peut se faire en gravure humide, par exemple à l'aide d'une solution de TMAH (hydroxyde de tétraméthylammonium). Une partie de la couche 12 HyBL est avantageusement conservée après ce retrait partiel, sous forme de bague ou de collier, entre le collier 13 et la partie inférieure 11b de la région 11, à la base de la LED. Cette partie de la couche 12 HyBL présente typiquement une hauteur h₁₂ sensiblement égale à la hauteur h₁₃ du collier 13. La hauteur h₁₂ selon z peut être comprise entre 30% et 50% de la hauteur h_{d} de la diode. La hauteur h₁₂ de la couche 12 HBL peut être ajustée en fonction d'un courant de fonctionnement nominal pour la diode. A l'issue de ce retrait, seule la partie supérieure 1a de la LED n'est pas couverte par la couche 12 HyBL. La partie supérieure 11a de la région 11 est ainsi exposée.

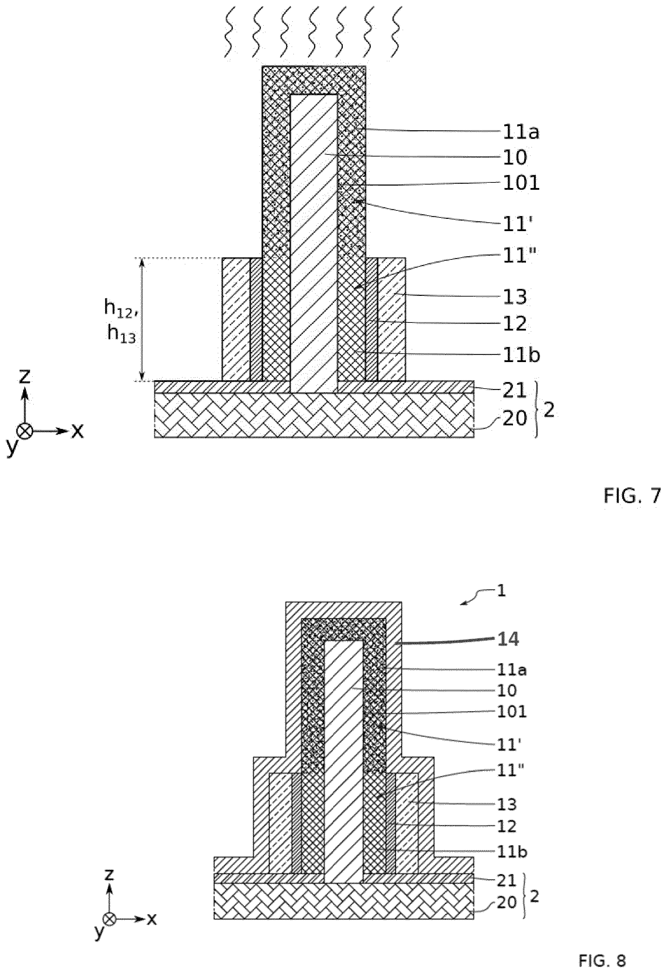

Selon un exemple de réalisation illustré à la figure 7, l'étape d'activation permettant de rendre effectif le dopage de la région 11 est effectuée après retrait partiel de la couche 12 HyBL et avant formation de l'électrode conductrice transparente. Cette étape d'activation se fait typiquement par recuit thermique sous atmosphère neutre ou oxydante, sans hydrogène, par exemple sous azote ou sous un mélange d'oxygène et d'azote. La température du recuit est de préférence supérieure à 500°C, par exemple de l'ordre de 650°C, lorsque l'atmosphère est oxydante. La température du recuit est de préférence supérieure à 700°C, par exemple de l'ordre de 750°C, lorsque l'atmosphère est neutre.

Cette étape d'activation permet d'activer localement la région 11 à base de GaN-p par relargage d'hydrogène. Une partie activée 11' est ainsi formée au niveau de la partie supérieure 1a de la LED. Cette partie activée 11' correspond sensiblement à la partie supérieure 11a de la région 11 qui présente le moins de défauts. Une telle partie activée 11' peut ainsi présenter une concentration d'accepteurs supérieure ou égale à 10¹⁸ cm⁻³, et de préférence supérieure ou égale à 10¹⁹ cm⁻³.

Grâce à la présence de la couche 12 HyBL, une partie inactivée 11" est également formée à l'issue de l'étape d'activation. Cette partie inactivée 11" correspond sensiblement à la partie inférieure 11b de la région 11 qui présente le plus de défauts. Une telle partie inactivée peut ainsi présenter une concentration d'accepteurs inférieure ou égale à 10¹⁶ cm⁻³, et de préférence inférieure ou égale à 10¹⁵ cm⁻³. La partie inactivée 11" est typiquement intercalée entre la région 10 d'injection d'électrons et la couche 12 HyBL.

Selon un exemple de réalisation illustré à la figure 8, une électrode 14 conductrice transparente, généralement appelée TCO (acronyme de « Transparent Conductive Oxyde »), est formée sur la partie activée 11' après activation. La couche 13 de passivation permet d'isoler électriquement la couche 12 HyBL de l'électrode 14 TCO.

De façon connue, l'électrode 14 TCO nécessite un recuit thermique, typiquement un recuit sous atmosphère oxydante, lors de sa formation.

Selon un exemple de réalisation non illustré, l'électrode TCO est formée sur la région 11 avant l'étape d'activation. Un recuit thermique sous atmosphère oxydante à une température de l'ordre de 650°C permet alors avantageusement de finaliser la formation de l'électrode TCO tout en réalisant simultanément l'étape d'activation permettant d'obtenir la partie activée 11' de la région 11. L'électrode TCO ne forme pas de barrière à la diffusion d'hydrogène. L'étape d'activation et le recuit du TCO peuvent ainsi être réalisés simultanément lors d'une seule et même étape. Cela permet d'économiser une étape de procédé.

Dans tous les cas, l'usage intentionnel de la couche 12 HyBL permet de former localement une partie inactivée 11". La partie inactivée 11" est choisie de façon à optimiser le fonctionnement de la LED. Selon le mode de réalisation illustré à la figure 8, cette partie inactivée 11" correspond avantageusement à la partie inférieure 11b d'une région 11 d'injection de trous d'une LED 3D à architecture cœur-coquille.

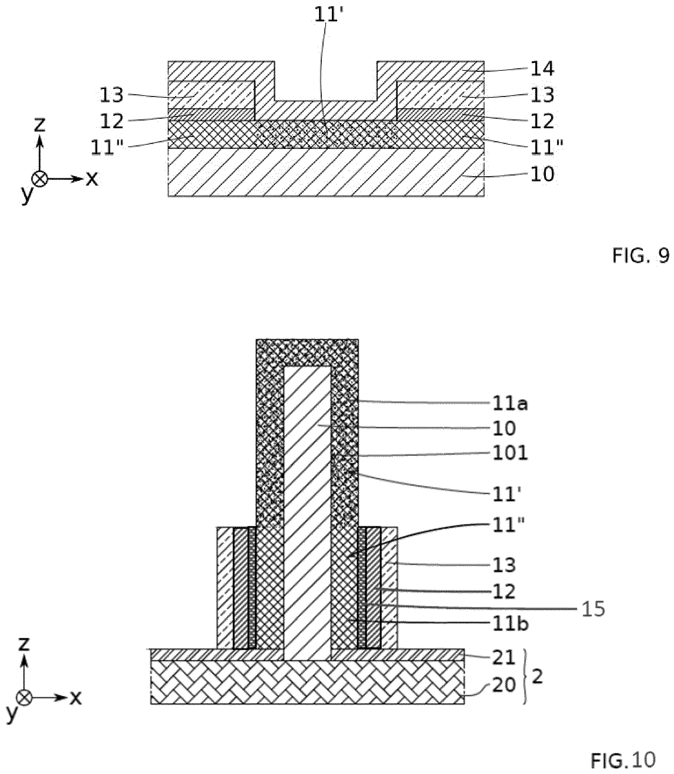

Selon un autre mode de réalisation illustré à la figure 9, la LED peut présenter une architecture 2D dite planaire. Dans ce cas, une couche 11 d'injection de trous est formée en empilement selon z sur une couche 10 d'injection d'électrons. La couche 12 HyBL est ensuite formée en empilement selon z sur la couche 11 d'injection de trous. La couche 13 de passivation est de préférence formée en empilement selon z sur la couche 12 HyBL. Une ouverture est ensuite formée, par exemple par lithographie/gravure, au travers des couches 13 et 12, de façon à exposer une partie de la couche 11 d'injection de trous. L'électrode 14 TCO est ensuite formée dans l'ouverture sur la partie exposée de la couche 11, avant ou après l'étape d'activation. Une LED 2D planaire comprenant une partie activée 11' et au moins une partie inactivée 11" est ainsi formée. Avantageusement, la partie activée peut être localisée au centre de la LED 2D tandis que la partie inactivée 11" peut être localisée en périphérie de la LED 2D.

Selon un autre mode de réalisation illustré à la figure 10, une couche 15 dite réservoir d'hydrogène peut être intercalée entre la partie inférieure 11b de la région 11 et la couche 12 HyBL. Cette couche 15 réservoir d'hydrogène est avantageusement configurée pour contenir une quantité initiale d'hydrogène avant l'étape d'activation de la partie supérieure 11a de la région 11, et pour libérer au moins une partie de cet hydrogène contenu initialement en direction de la partie inférieure 11b de la région 11, de préférence lors de l'étape d'activation. Il se produit ainsi typiquement une exodiffusion de l'hydrogène depuis la couche 15 réservoir d'hydrogène vers la partie inférieure 11b de la région 11, majoritairement lors de l'étape d'activation. Cela permet d'enrichir la partie inférieure 11b de la région 11 en hydrogène, ce qui inactive les éléments dopants de cette partie inférieure 11b. La couche 15 réservoir d'hydrogène permet d'injecter, par diffusion, de l'hydrogène au sein de la partie inférieure 11b. Ainsi, l'effet d'inactivation de la partie inférieure 11b obtenu dans les autres modes de réalisation grâce à la présence de la couche 12 HyBL, est ici majoré ou amplifié par la présence de cette couche 15 réservoir d'hydrogène apportant directement un supplément d'hydrogène au sein de la partie inférieure 11b.

La quantité d'hydrogène à diffuser depuis la couche 15 réservoir d'hydrogène vers la partie inférieure 11b n'est pas nécessairement élevée. Des traces peuvent suffire à inactiver la partie inférieure 11b.

On choisira de préférence la couche 15 réservoir d'hydrogène en un matériau présentant une quantité d'hydrogène initiale de quelques pourcents à quelques dizaines de pourcents et permettant de relarguer cet hydrogène dans le matériau de la partie inférieure 11b, notamment lors de l'activation. Le nitrure de silicium, en particulier lorsqu'il est déposé par dépôt chimique en phase vapeur assisté par plasma PECVD (acronyme de « Plasma Enhanced Chemical Vapor Deposition »), contient typiquement de 0,1% à 10%, voire jusqu'à 20% d'hydrogène en concentration atomique. Le nitrure de silicium forme ainsi une source d'hydrogène qui convient pour la couche 15 réservoir d'hydrogène. La fragilité des liaisons Si-H et N-H, et la mobilité de l'hydrogène dans ce matériau permettent une bonne exodiffusion de l'hydrogène vers le matériau semiconducteur de la partie inférieure 11b. D'autres matériaux peuvent également convenir pour la couche 15 réservoir d'hydrogène, en particulier des matériaux nitrurés tels que SiN, Si3N4, SiCN.

La couche 15 réservoir d'hydrogène présente de préférence une épaisseur comprise entre 2 nm et 20 nm, typiquement de l'ordre de 5 nm.

Cette couche 15 réservoir d'hydrogène peut être typiquement formée par dépôt conforme PECVD sur la région 11 avant dépôt de la couche 12 HyBL et dela couche 13 de passivation. Un retrait partiel au niveau de la partie supérieure 1a de la LED peut être effectué de façon connue par gravure isotrope du matériau de la couche 15 sélectivement aux autres matériaux constitutifs de la LED. La gravure isotrope peut se faire en gravure humide ou gravure sèche, par exemple à l'aide d'un plasma fluoré ou fluorocarboné. Une partie de la couche 15 est avantageusement conservée après ce retrait partiel, sous forme de bague ou de collier, entre la partie inférieure 11b de la région 11 et la couche 12 HyBL, à la base de la LED. Cette partie de la couche 15 présente typiquement une hauteur sensiblement égale à la hauteur du collier 13. A l'issue de ce retrait, seule la partie supérieure 1a de la LED n'est pas couverte par la couche 15. Ce mode de réalisation illustré à la figure 10 produit un effet supplémentaire pour l'inactivation de la partie inférieure 11b, grâce à la couche 15 réservoir d'hydrogène. Ce mode de réalisation peut naturellement être adapté à une architecture planaire 2D telle qu'illustrée à la figure 9, en prévoyant une couche 15 réservoir d'hydrogène intercalée entre la couche 12 HyBL et la partie inactivée 11".

L'invention n'est pas limitée aux modes de réalisations précédemment décrits et s'étend à tous les modes de réalisation couverts par les revendications.

En particulier, les dimensions de la couche HyBL peuvent être ajustées de façon à limiter la partie activée à un courant de fonctionnement donné, et/ou à une zone d'intérêt de la LED.

## Revendications

1. Diode électroluminescente (1) à base de GaN comprenant :
- une région (10) d'injection d'électrons à base de GaN-n,
- une région (11, 11') d'injection de trous à base de GaN-p,
- une région active (101) située entre la région (10) d'injection d'électrons et la région (11, 11') d'injection de trous, configurée pour émettre un rayonnement lumineux,
dans laquelle la région (11, 11') d'injection de trous comprend au moins une partie activée (11') et au moins une partie inactivée (11") telles que la partie activée (11') présente une concentration d'accepteurs au moins dix fois supérieure à une concentration d'accepteurs de la partie inactivée (11"), dans laquelle ladite au moins une partie inactivée (11") est intercalée entre la région (10) d'injection d'électrons et une couche (12) de blocage d'hydrogène configurée pour empêcher un relargage d'hydrogène depuis la partie inactivée (11") lors d'une activation de la partie activée (11'), et dans laquelle la partie inactivée (11") présente un taux de défauts supérieur au taux de défauts de la partie activée (11').

2. Diode électroluminescente (1) selon la revendication précédente dans laquelle la couche (12) de blocage d'hydrogène couvre, pour la région (11) d'injection de trous, uniquement l'au moins une partie inactivée (11").

3. Diode électroluminescente (1) selon l'une quelconque des revendications précédentes comprenant une couche (15) dite réservoir d'hydrogène intercalée entre la couche (12) de blocage d'hydrogène et la partie inactivée (11"), ladite couche (15) réservoir d'hydrogène étant configurée pour apporter un supplément d'hydrogène au sein de la partie inactivée (11") au moins lors de l'activation de la partie activée (11').

4. Diode électroluminescente (1) selon la revendication précédente dans laquelle la couche (15) réservoir d'hydrogène est à base de nitrure de silicium présentant une concentration atomique d'hydrogène comprise entre 0,1 et 20%.

5. Diode électroluminescente (1) selon l'une quelconque des revendications 1 à 2 dans laquelle la couche (12) de blocage d'hydrogène est directement au contact de l'au moins une partie inactivée (11").

6. Diode électroluminescente (1) selon l'une quelconque des revendications précédentes comprenant en outre une couche (13) de passivation s'étendant au contact de la couche (12) de blocage d'hydrogène.

7. Diode électroluminescente (1) selon l'une quelconque des revendications précédentes dans laquelle la région active (101) se présente au sein d'une jonction PN entre les régions (11, 10) d'injection de trous et d'électrons.

8. Diode électroluminescente (1) selon l'une quelconque des revendications précédentes dans laquelle la couche (12) de blocage d'hydrogène est à base de l'un au moins parmi l'AIN, le GaN-n, l'AlGaN-n.

9. Diode électroluminescente (1) selon l'une quelconque des revendications précédentes dans laquelle les régions (10, 11) d'injection d'électrons et de trous s'étendent le long d'un plan basal (xy), et dans laquelle la couche (12) de blocage d'hydrogène présente au moins une ouverture configurée pour exposer la partie activée (11') de la région (11) d'injection de trous.

10. Diode électroluminescente (1) selon l'une quelconque des revendications précédentes dans laquelle la région (10) d'injection d'électrons s'étend longitudinalement sous forme de fil selon une direction longitudinale (z) et la région (11) d'injection de trous s'étend radialement autour de la région (10) d'injection d'électrons, de sorte que la diode (1) présente une architecture dite cœur-coquille, et dans laquelle la couche (12) de blocage d'hydrogène s'étend radialement sous forme de bague autour de la partie inactivée (11").

11. Diode électroluminescente (1) selon la revendication précédente dans laquelle la couche (12) de blocage d'hydrogène sous forme de bague est située au niveau d'une base de la diode (1) prenant appui sur un substrat (2).

12. Diode électroluminescente (1) selon l'une quelconque des revendications 10 à 11 dans laquelle la couche (12) de blocage d'hydrogène présente une hauteur h12 selon la direction longitudinale (z) comprise entre 30% et 50% d'une hauteur hd de la diode prise selon la direction longitudinale (z).

13. Diode électroluminescente (1) selon l'une quelconque des revendications 10 à 12 comprenant en outre une couche (15) réservoir d'hydrogène s'étendant radialement autour de la partie inactivée (11"), entre la partie inactivée (11") et la couche (12) de blocage d'hydrogène.

14. Diode électroluminescente (1) selon l'une quelconque des revendications 10 à 13 comprenant en outre une couche (13) de passivation s'étendant radialement autour de la couche (12) de blocage d'hydrogène.

15. Procédé de fabrication d'une diode électroluminescente (1) à base de GaN comprenant au moins les étapes suivantes :
- Une formation d'une région (10) d'injection d'électrons à base de GaN-n,
- Une formation d'une région (11) d'injection de trous à base de GaN-p,
- Une formation d'une région active (101) située entre la région (10) d'injection d'électrons et la région (11) d'injection de trous, ladite région active (101) étant configurée pour émettre un rayonnement lumineux,
- Une activation thermique configurée pour activer la région (11, 11') d'injection de trous,
dans lequel une couche (12) de blocage d'hydrogène est formée avant l'activation et sur une partie (11") seulement de la région (11) d'injection de trous, de sorte que l'activation soit empêchée au niveau de ladite partie (11") de la région (11) d'injection de trous, dite partie inactivée (11"), et que l'activation soit effective sur une autre partie (11') de la région (11) d'injection de trous, dite partie activée (11'), et que ladite partie inactivée (11") soit intercalée entre la région (10) d'injection d'électrons et la couche (12) de blocage d'hydrogène, la partie activée (11') présentant une concentration d'accepteurs au moins dix fois supérieure à une concentration d'accepteurs de la partie inactivée (11"), et la partie inactivée (11") présentant un taux de défauts supérieur au taux de défauts de la partie activée (11').

## Patentansprüche

1. Leuchtdiode (1) auf GaN-Basis, umfassend:
- einen Elektroneninjektionsbereich (10) auf GaN-n-Basis,
- einen Lochinjektionsbereich (11, 11') auf GaN-p-Basis,
- einen aktiven Bereich (101), der sich zwischen dem Elektroneninjektionsbereich (10) und dem Lochinjektionsbereich (11, 11') befindet und so eingerichtet ist, dass er eine Lichtstrahlung aussendet, wobei der Lochinjektionsbereich (11, 11') mindestens einen aktivierten Teil (11') und mindestens einen inaktivierten Teil (11") umfasst, so dass der aktivierte Teil (11') eine Akzeptorkonzentration aufweist, die mindestens zehnfach höher ist als eine Akzeptorkonzentration des inaktivierten Teils (11"), wobei der mindestens eine inaktivierte Teil (11") zwischen dem Elektroneninjektionsbereich (10) und einer Wasserstoffsperrschicht (12) eingefügt ist, die so eingerichtet ist, dass sie ein Freisetzen von Wasserstoff aus dem inaktivierten Teil (11") bei einem Aktivieren des aktivierten Teils (11') verhindert, und wobei der inaktivierte Teil (11") eine Fehlerrate aufweist, die größer ist als die Fehlerrate des aktivierten Teils (11').

2. Leuchtdiode (1) nach dem vorhergehenden Anspruch, wobei die Wasserstoffsperrschicht (12) für den Lochinjektionsbereich (11) nur den mindestens einen inaktivierten Teil (11") abdeckt.

3. Leuchtdiode (1) nach einem der vorhergehenden Ansprüche, die eine Wasserstoffreservoirschicht (15) umfasst, die zwischen der Wasserstoffsperrschicht (12) und dem inaktivierten Teil (11") eingefügt ist, wobei die Wasserstoffreservoirschicht (15) so eingerichtet ist, dass sie mindestens beim Aktivieren des aktivierten Teils (11') einen zusätzlichen Wasserstoff innerhalb des inaktivierten Teils (11") bereitstellt.

4. Leuchtdiode (1) nach dem vorhergehenden Anspruch, wobei die Wasserstoffreservoirschicht (15) auf Siliziumnitrid basiert und eine Wasserstoffatomkonzentration zwischen 0,1 und 20 % aufweist.

5. Leuchtdiode (1) nach einem der Ansprüche 1 bis 2, wobei die Wasserstoffsperrschicht (12) direkt mit dem mindestens einen inaktivierten Teil (11") in Kontakt steht.

6. Leuchtdiode (1) nach einem der vorhergehenden Ansprüche, die ferner eine Passivierungsschicht (13) umfasst, die sich in Kontakt mit der Wasserstoffsperrschicht (12) erstreckt.

7. Leuchtdiode (1) nach einem der vorhergehenden Ansprüche, wobei der aktive Bereich (101) innerhalb eines PN-Übergangs zwischen den Loch- und Elektroneninjektionsbereichen (11, 10) vorliegt.

8. Leuchtdiode (1) nach einem der vorhergehenden Ansprüche, wobei die Wasserstoffsperrschicht (12) auf mindestens einem von AlN, GaN-n und AlGaN-n basiert.

9. Leuchtdiode (1) nach einem der vorhergehenden Ansprüche, wobei sich die Elektronen- und Lochinjektionsbereiche (10, 11) entlang einer Basalebene (xy) erstrecken, und wobei die Wasserstoffsperrschicht (12) mindestens eine Öffnung aufweist, die so eingerichtet ist, dass sie den aktivierten Teil (11') des Lochinjektionsbereichs (11) freilegt.

10. Leuchtdiode (1) nach einem der vorhergehenden Ansprüche, wobei sich der Elektroneninjektionsbereich (10) längsdrahtförmig in einer Längsrichtung (z) erstreckt und sich der Lochinjektionsbereich (11) radial um den Elektroneninjektionsbereich (10) herum erstreckt, so dass die Diode (1) eine Kern-Schale-Architektur aufweist, und wobei sich die Wasserstoffsperrschicht (12) radial ringförmig um den inaktivierten Teil (11") herum erstreckt.

11. Leuchtdiode (1) nach dem vorhergehenden Anspruch, wobei sich die ringförmige Wasserstoffsperrschicht (12) an einer Basis der Diode (1) befindet, die auf einem Substrat (2) aufliegt.

12. Leuchtdiode (1) nach einem der Ansprüche 10 bis 11, wobei die Wasserstoffsperrschicht (12) eine Höhe h12 in der Längsrichtung (z) aufweist, die zwischen 30 % und 50 % einer Höhe hd der Diode in der Längsrichtung (z) beträgt.

13. Leuchtdiode (1) nach einem der Ansprüche 10 bis 12, die ferner eine Wasserstoffreservoirschicht (15) umfasst, sich radial um den inaktivierten Teil (11") herum zwischen dem inaktivierten Teil (11") und der Wasserstoffsperrschicht (12) erstreckt.

14. Leuchtdiode (1) nach einem der Ansprüche 10 bis 13, die ferner eine Passivierungsschicht (13) umfasst, die sich radial um die Wasserstoffsperrschicht (12) herum erstreckt.

15. Verfahren zum Herstellen einer Leuchtdiode (1) auf GaN-Basis, das mindestens die folgenden Schritte umfasst:
- Bilden eines Elektroneninjektionsbereichs (10) auf GaN-n-Basis,
- Bilden eines Lochinjektionsbereichs (11) auf GaN-p-Basis,
- Bilden eines aktiven Bereichs (101), der sich zwischen dem Elektroneninjektionsbereich (10) und dem Lochinjektionsbereich (11) befindet, wobei der aktive Bereich (101) so eingerichtet ist, dass er eine Lichtstrahlung aussendet,
- thermisches Aktivieren, das so eingerichtet ist, dass es den Lochinjektionsbereich (11, 11') aktiviert, wobei vor dem Aktivieren und nur auf einem Teil (11") des Lochinjektionsbereichs (11) eine Wasserstoffsperrschicht (12) gebildet wird, so dass das Aktivieren auf Höhe des Teils (11") des Lochinjektionsbereichs (11), des inaktivierten Teils (11"), verhindert wird und das Aktivieren auf einem anderen Teil (11') des Lochinjektionsbereichs (11), dem aktivierten Teil (11'), wirksam ist, und dass der inaktivierte Teil (11") zwischen dem Elektroneninjektionsbereich (10) und der Wasserstoffsperrschicht (12) eingefügt ist, wobei der aktivierte Teil (11') eine Akzeptorkonzentration aufweist, die mindestens zehnfach höher ist als eine Akzeptorkonzentration des inaktivierten Teils (11"), und der inaktivierte Teil (11") eine Fehlerrate aufweist, die höher ist als die Fehlerrate des aktivierten Teils (11').

## Claims

1. GaN-based light emitting diode (1) comprising:
- a GaN-n-based electron injection area (10),
- a GaN-p-based hole injection area (11, 11'),
- an active area (101) located between the electron injection area (10) and the hole injection area (11, 11'), configured to emit light radiation,
wherein the hole injection area (11, 11') comprises at least one activated portion (11') and at least one inactivated portion (11") such that the activated portion (11') has an acceptor concentration at least ten times greater than an acceptor concentration of the inactivated portion (11"), wherein said at least one inactivated portion (11") is interposed between the electron injection area (10) and a hydrogen blocking layer (12) configured to prevent hydrogen release from the inactivated portion (11") upon activation of the activated portion (11'), and wherein the inactivated portion (11") has a defect rate greater than the defect rate of the activated portion (11').

2. Light-emitting diode (1) according to the preceding claim, wherein the hydrogen blocking layer (12) covers, for the hole injection area (11), only the at least one inactivated portion (11").

3. Light-emitting diode (1) according to any one of the preceding claims comprising a so-called hydrogen reservoir layer (15) interposed between the hydrogen blocking layer (12) and the inactivated portion (11"), said hydrogen reservoir layer (15) being configured to provide a supplement of hydrogen within the inactivated portion (11") at least upon activation of the activated portion (11').

4. Light-emitting diode (1) according to the preceding claim, wherein the hydrogen reservoir layer (15) is based on silicon nitride having a hydrogen atomic concentration between 0.1 and 20%.

5. Light-emitting diode (1) according to either one of Claims 1 or 2, wherein the hydrogen blocking layer (12) is directly in contact with the at least one inactivated portion (11").

6. Light-emitting diode (1) according to any one of the preceding claims further comprising a passivation layer (13) extending in contact with the hydrogen blocking layer (12).

7. Light-emitting diode (1) according to any one of the preceding claims wherein the active area (101) is located within a junction PN between the hole and electron injection areas (11, 10).

8. Light-emitting diode (1) according to any one of the preceding claims wherein the hydrogen blocking layer (12) is based on at least one of AlN, GaN-n, AlGaN-n.

9. Light-emitting diode (1) according to any one of the preceding claims wherein the electron and hole injection areas (10, 11) extend along a basal plane (xy), and wherein the hydrogen blocking layer (12) has at least one opening configured to expose the activated portion (11') of the hole injection area (11).

10. Light-emitting diode (1) according to any one of the preceding claims wherein the electron injection area (10) extends longitudinally in the form of a wire along a longitudinal direction (z) and the hole injection area (11) extends radially around the electron injection area (10), such that the diode (1) has a so-called core-shell structure, and wherein the hydrogen blocking layer (12) extends radially in the form of a ring around the inactivated portion (11").

11. Light-emitting diode (1) according to the preceding claim, wherein the hydrogen blocking layer (12) in the form of a ring is located at a base of the diode (1) resting on a substrate (2).

12. Light-emitting diode (1) according to either one of Claims 10 or 11, wherein the hydrogen blocking layer (12) has a height h12 in the longitudinal direction (z) of between 30% and 50% of a height hd of the diode in the longitudinal direction (z).

13. Light-emitting diode (1) according to any one of Claims 10 to 12 further comprising a hydrogen reservoir layer (15) extending radially around the inactivated portion (11"), between the inactivated portion (11") and the hydrogen blocking layer (12).

14. Light-emitting diode (1) according to any one of Claims 10 to 13 further comprising a passivation layer (13) extending radially around the hydrogen blocking layer (12).

15. Method for manufacturing a GaN-based light-emitting diode (1) comprising at least the following steps:
- forming a GaN-n-based electron injection area (10),
- forming a GaN-p-based hole injection area (11),
- forming an active area (101) located between the electron injection area (10) and the hole injection area (11), said active area (101) being configured to emit light radiation,
- thermal activation configured to activate the hole injection area (11, 11'), wherein a hydrogen blocking layer (12) is formed before activation and on only a portion (11") of the hole injection area (11), such that activation is prevented at said portion (11") of the hole injection area (11), said inactivated portion (11"), and activation is effective on another portion (11') of the hole injection area (11), said activated portion (11'), and said inactivated portion (11") is interposed between the electron injection area (10) and the hydrogen blocking layer (12), the activated portion (11') having an acceptor concentration at least ten times greater than an acceptor concentration of the inactivated portion (11"), and the inactivated portion (11") having a defect rate greater than the defect rate of the activated portion (11').
